Europäisches Patentamt

European Patent Office

Office européen des brevets

(11) Veröffentlichungsnummer: **0 257 120 B1**

## (12) EUROPÄISCHE PATENTSCHRIFT

(45) Veröffentlichungstag der Patentschrift: **10.06.92**

(21) Anmeldenummer: **86111646.5**

(22) Anmeldetag: **22.08.86**

(51) Int. Cl.⁵: **G06F 11/20**

(54) Dekodierverfahren und -Schaltungsanordnung für einen redundanten CMOS-Halbleiterspeicher.

(43) Veröffentlichungstag der Anmeldung:
**02.03.88 Patentblatt 88/09**

(45) Bekanntmachung des Hinweises auf die
Patenterteilung:
**10.06.92 Patentblatt 92/24**

(84) Benannte Vertragsstaaten:
**DE FR GB**

(56) Entgegenhaltungen:
**EP-A- 0 029 322**
**EP-A- 0 155 829**
**GB-A- 2 165 378**

(73) Patentinhaber: **International Business Machines Corporation**
**Old Orchard Road**
**Armonk, N.Y. 10504(US)**

(72) Erfinder: **Loehlein, W.D., Elektro-Ing.**
**Goldregenstrasse 2**
**W-7033 Herrenberg(DE)**
Erfinder: **Tong, M.H., Dipl.-Ing.**
**Rhönweg 22B**
**W-7030 Böblingen(DE)**
Erfinder: **Helwig, K. Dipl.-Ing.**
**Richard Wagner Strasse 23**
**W-7032 Sindelfingen(DE)**

(74) Vertreter: **Rudolph, Wolfgang, Dipl.-Ing.**
**IBM Deutschland GmbH Schönaicher Strasse 220**
**W-7030 Böblingen(DE)**

**Beschreibung**

Die Erfindung betrifft ein Dekodierverfahren für einen Halbleiterspeicher mit redundanten Wort- oder Bitleitungen nach dem Oberbegriff des Patentanspruchs 1 und eine Schaltungsanordnung zur Durchführung des Verfahrens.

Bei der Herstellung monolithischer, integrierter Speicheranordnungen mit ihren Zugriffsschaltungen wie Bitdekodern, ist die Verringerung des Stromverbrauchs eine primäre Forderung. Zunächst hat man große Anstrengungen bei der Verringerung des Strombedarfs der Speicherzeilen selbst gemacht, und dann mit fortschreitender Integrationsdichte hat man auch versucht, den Stromverbrauch in der Speicherperipherie, die zum Beispiel in den Dekodierern zu verringern.

So ist z.B. ein impulsbetriebenes Dekodiersystem durch die US-A-3 573 759 bekannt, das den Stromverbrauch sowohl in den Ansteuerschaltkreisen als auch in den Dekodierschaltkreisen des monolithischen, integrierten Speichers verringert. Dies wird dadurch erreicht, daß die Dekodierstromkreise dann auf einem minimal notwendigen Strompegel gehalten werden, wenn kein Zugriff zum Speicher stattfindet. Auch wenn keine Information aus dem Speicher gelesen wird bzw. in den Speicher geschrieben wird, werden die erforderlichen Strompegel dafür auf einem sehr geringen Wert gehalten. Eine Leistungsverringerung ergibt sich damit lediglich in einer bestimmten Zeitperiode des Speichers, nämlich in der, in der kein Zugriff stattfindet. Außerdem hat eine derartige Schaltung noch den Nachteil, daß sie im Verhältnis zu den Schaltungen, die immer mit vollem Strom betrieben werden, sehr langsam ist. Sie eignet sich deshalb nicht für moderne monolithische Speicher, bei denen es neben der äußerst geringen Verlustleistung auch auf höchste Leistungsfähigkeit, d.h. schnellen Zugriff und hohe Lese/Schreibgeschwindigkeit ankommt. Für CMOS-Speicher sind solche Dekoder, z.B. beschrieben in IBM TDB Vol. 25, Nr. 3B, August 82, Seiten 1735 und 1736. CMOS-Speicher, die einen sehr kleinen Strom benötigen, sind zum Beispiel beschrieben im US-A-4 251 876 und in der entsprechenden deutschen Offenlegungsschrift 2 751 481. Adressendekodierschaltungen mit einem geringen Stromverbrauch sind außerdem im US-A-3 665 473 beschrieben. Jedoch zeigen alle diese bekannten Dekodierschaltkreise und CMOS-Speicher keine Lösung für solche Speicher, die zum Zwecke der höheren Sicherheit mit redundanten Wort- und/oder Bitleitungen ausgelegt sind. Solche Speicher sind prinzipiell beschrieben in dem IBM TDB Vol. 7, Nr. 9, Februar 1965, Seite 808 und US-A-3 222 653 sowie DE-A 2 144 870. Obwohl in diesen beiden letztgenannten Schriften bereits Speicher mit redundanten Wortleitungen oder Bitleitungen beschrieben sind, eignen sich die darin gemachten Vorschläge nicht für moderne Speicher, weil sie nicht die Dekoder für die redundanten Wortleitungen in ein Konzept zur Leistungsreduzierung und Geschwindigkeitserhöhung einbeziehen. Bei modernen Halbleiterspeichern, insbesondere bei sehr schnellen CMOS-Speichern mit redundanten Wort- oder Bitleitungen mit sehr geringer Verlustleistung ist es erforderlich, daß auch die Dekoder und Treiber voll in dieses Konzept mit einbezogen werden.

Aus der EP-A-0 155 829 ist auch ein redundanter Speicher bekannt, bei dem die Zugriffszeit verkürzt wird, indem parallel Adressen verglichen werden. Aus dieser Schrift ist auch bekannt, innerhalb eines redundanten Speichers einen Clamp-Schaltkreis zu verwenden, um unselektierte Wortleitungen auf niedrigem Pegel zu halten.

Aus der britischen Patentanmeldung 2 165 378A ist ein Dekodierverfahren für einen redundanten CMOS-Halbleiterspeicher bekannt, bei dem zur Dekodierung von Wort- und/oder Bitleitungen in einem CMOS-Halbleiterspeicher mit redundanten Wort- und/oder Bitleitungen und Verbindungen (Fuses) zur Darstellung der Adressen der redundanten Wort- und/oder Bitleitungen, die über einen Vergleicher mit von außen an den Speicher zur gewünschten Selektion angelegten Adressen verglichen werden, indem die von außen angelegten Adressen gleichzeitig auf die Dekoder (1 und 2) des Speichers und auf einen Vergleicher (4) gegeben werden, an dem auch die Adressen (FA) für die Fuses anliegen, indem im Falle eines Match-Signals, hervorgerufen durch den Vergleich der von außen angelegten Adressen mit der Adresse, die durch die Fuses eingestellt ist, sofort die redundante Wortleitung (RWL) aktiviert wird und gleichzeitig alle Wort- (WL) oder Bitleitungen im unselektierten Zustand gehalten werden.

Der Erfindung liegt deshalb die Aufgabe zugrunde, ein Verfahren und eine Schaltungsanordnung zur Dekodierung von Wort- oder Bitleitungen in einem CMOS-Halbleiterspeicher mit redundanten Wort- oder Bitleitungen zu schaffen, bei denen die Vorteile der parallelen AnSteuerung der normalen Wortleitungen und der redundanten Wortleitungen bei niedrigem Pegel für den Schreib- bzw. den Lesestrom so genutzt werden, daß trotzdem das sehr schnelle Schreiben bzw. Lesen des CMOS-Speichers nicht nachteilig beeinflußt wird und mit geringen schaltungstechnischen Mitteln erreicht wird.

Die erfindungsgemäße Lösung der Aufgabe besteht in einem Verfahren nach dem Patentanspruch 1 und in einer Schaltungsanordnung nach Patentanspruch 2.

Weitere Ausgestaltungen der Erfindungen sind in den Unteransprüchen charakterisiert.

Die erfindungsgemäße Lösung zeichnet sich vor allem dadurch aus, daß in einmaliger Weise das Konzept der parallelen Dekodierung, sowohl der normalen Wortleitungen als auch der redundanten Wortleitungen in dem Zustand des Speichers erfolgt, in dem der Schreib- bzw der Lesestrom sich auf seinem niedrigen Pegel befindet. Damit wird einmal erreicht, daß die Auswahl der redundanten Wortleitung nicht in einer nachfolgenden zeitraubenden Operation wie bisher erfolgt, sondern parallel zur Auswahl der normalen Wortleitung. Außerdem wird durch diese Lösung erreicht, daß die Verlustleistung äußerst gering gehalten wird. Eine derartige Kombination wird vor allem durch die Anordnung einer direkten Adressverbindung über "Fuses"-kontrollierte Schalter erzielt und dadurch, daß gleichzeitig alle Wort- oder Bitleitungen des Speichers durch einen Clamp-Schaltkreis im unselektierten Zustand bleiben. Dieser Clamp-Schaltkreis ist am Ausgang des Adressdekoders unmittelbar vor den Treiberstufen angeordnet. Das Clamp-Signal wird auch weiterhin dazu benutzt, die Adressdekoder zu deaktivieren und eine Restore-Operation des Adressdekoders einzuleiten, wodurch dieser sofort wieder empfangsbereit wird.

Die Erfindung wird nun anhand von in den Zeichnungen dargestellten Ausführungsbeispielen näher beschrieben.

In der Zeichnung bedeuten:

Fig. 1 ein Blockschaltbild eines Speichers mit dem erfindungsgemäßen Dekodierschema und -schaltkreis,

Fig. 2 ein Zeitdiagramm für die Schaltungen nach Fig. 1 und 3 sowie

Fig. 3 ein detailliertes Schaltdiagramm zur genaueren Erklärung der vorliegenden Erfindung.

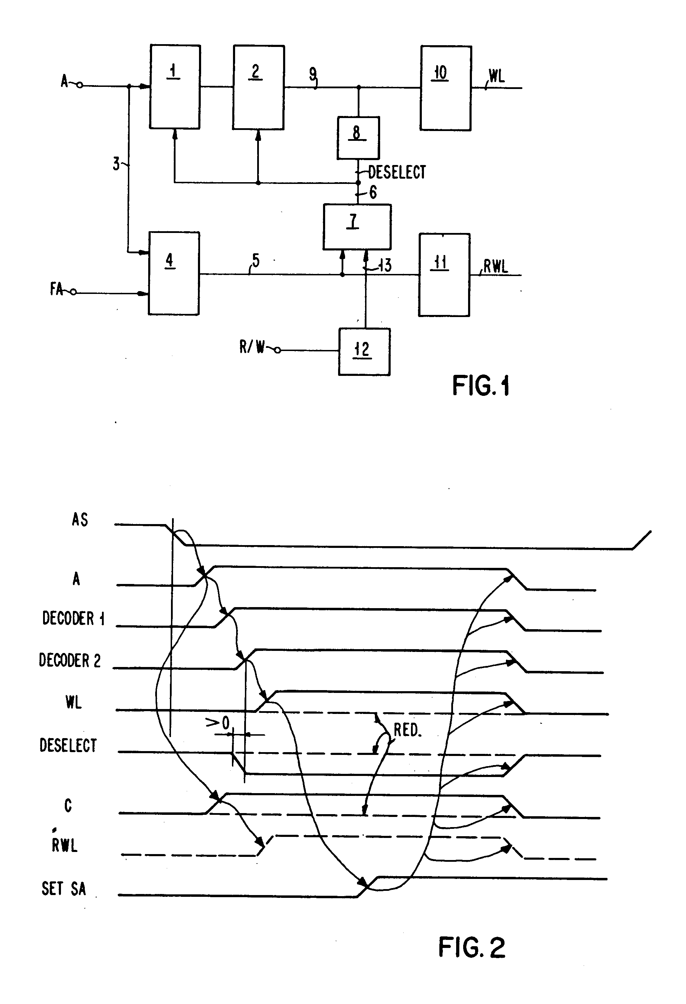

In Fig. 1 ist ein Blockschaltbild dargestellt, das von den bekannten Verfahren für CMOS-Speicher zum Adressendekodieren Gebrauch macht, indem mehrere partielle Dekoderstufen vorgesehen sind. Wie aus Fig. 1 zu sehen, wird eine Wortleitung WL über einen Vordekoder 1 und einen Dekoder 2 ausgewählt. Die Adressen A werden dazu zunächst an die Adressleitung 3 angelegt und gelangen parallel auf den einen Eingang eines Vergleichsschaltkreises 4. Das heißt mit anderen Worten, die Adressen, die am Vordekoder 1 anliegen, werden parallel auch dem Vergleichsschaltkreis 4 zugeführt, an dem die "Fuses"-Adressen FA anliegen. Die "Fuses" sind zum Ersatz einer defekten Wort- oder Bitleitung durch eine entsprechende Redundanzleitung gesetzt worden. Diese Operation ist bekannt und nicht Gegenstand der vorliegenden Erfindung. Im Falle einer normalen Selektion einer Wortleitung WL wird am Ausgang 5 des Vergleichsschaltkreises 4 kein "Match"- Signal erzeugt, wodurch das DESELECT-Signal am Ausgang 6 des ODER-Schaltkreises 7 auf 0 Volt gebracht wird. Durch diese Operation der Schaltung wird der einen Feldeffekttransistor umfassende Clamp-Schaltkreis 8 abgeschaltet, und damit kann eine dekodierte Adresse vom Ausgang 9 des Dekoders 2 auf die nachgeschaltete Treiberschaltung 10 gelangen. Die Treiberschaltung 10 bringt jetzt ihrerseits das Potential der zugeordneten Wortleitung WL hoch.

Da der Vergleich zwischen anliegender Adresse und Fuse-Adresse in der vorliegenden Schaltung immer frühzeitig erfolgt, gelangt durch die wenigen Schaltstufen das DESELECT-Signal immer vor dem Signal auf dem Dekoderausgang als gültig, wodurch der normale Dekoderpfad nicht beeinflußt wird (siehe auch das Zeitdiagramm). Bei der Aktivierung einer redundanten Wortleitung RWL geht dieser Aktivierung ein Match-Signal am Ausgang 5 des Vergleichers 4 voraus. Durch das Match-Signal wird die entsprechende redundante Wortleitung RWL über den mit ihr verbundenen Treiber 11 direkt aktiviert. Das heißt mit anderen Worten, hierdurch erfolgt kein Zeitverlust bei der Selektion einer redundanten Wortleitung RWL. Wichtig ist noch, daß das DESELECT-Signal erhalten bleibt, wodurch eine dekodierte Wortadresse nicht in der Lage ist, über den Clamp-Schaltkreis 8 die entsprechende defekte Wortleitung WL zu adressieren. Da, wie schon erwähnt wurde, der Pfad über den Vergleicher 4 zur redundanten Wortleitung RWL wesentlich schneller ist, kommt bei der Aktivierung einer redundanten Wortleitung RWL diese sogar früher, was sich auf die Zugriffszeit des Speichers dahingehend vorteilhaft auswirkt, daß diese sehr schnell wird. Ein aktives DESELECT-Signal leitet gleichzeitig beim Adressdekoder des vorliegenden Speichers einen Restore-Vorgang ein, wodurch der Clamp-Vorgang und damit die aufzubringende Leistung auf ein Minimum begrenzt wird. Weil der Clamp-Schaltkreis 8 vom Ausgang des ODER-Schaltkreises 6 gesteuert wird, dessen einer Eingang 13 vom Lese-/Schreib-Steuerschaltkreis 12 gesteuert wird, läßt sich durch diesen Clamp-Schaltkreis 8 eine vom Lese-/Schreib-Signal R/W gesteuerte gleichzeitige Abschaltung einer Wortleitung WL durchführen. Hierbei wird bei einem Lesevorgang ein Signal aus der Zeitsignalkette zurückgeführt, und über den ODER-Schaltkreis 7 wird somit die entsprechende Wortleitung WL abgeschaltet. Die Rückführung eines Signals aus der Zeitsignalkette kann dabei durch den Lese-/Schreibschaltkreis 12 an den ODER-Schaltkreis erfolgen. Da die Anwendung dieses Signals von der jeweiligen Schaltung abhängt, ist dieses Signal nicht in diese Schaltung eingezeichnet worden. Wird das Signal vom Leseverstärker benutzt, so bedeutet das, daß schon während des Verstärkungsvorgangs die Wortleitung WL abgeschaltet wird. Dies hat den Vorteil, daß sich die Bitleitung nur um das unverstärkte Signal entladen hat und demzufolge bei dem normalen Restorevorgang kaum Leistung aufgewendet werden muß (siehe auch Fig. 2). Das Signal SET SA (Fig. 2) vom Leseverstärker 10 reaktiviert alle Signale, wie aus dem Impulsdiagramm nach Fig. 2 zu ersehen ist, und leitet den normalen Restore-Vorgang ein. Für den Schreibfall muß die entsprechende Bitleitung auf 0 Volt heruntergezogen werden, wodurch sich eine zeitlich spätere Abschaltung der Wortleitung WL ergibt.

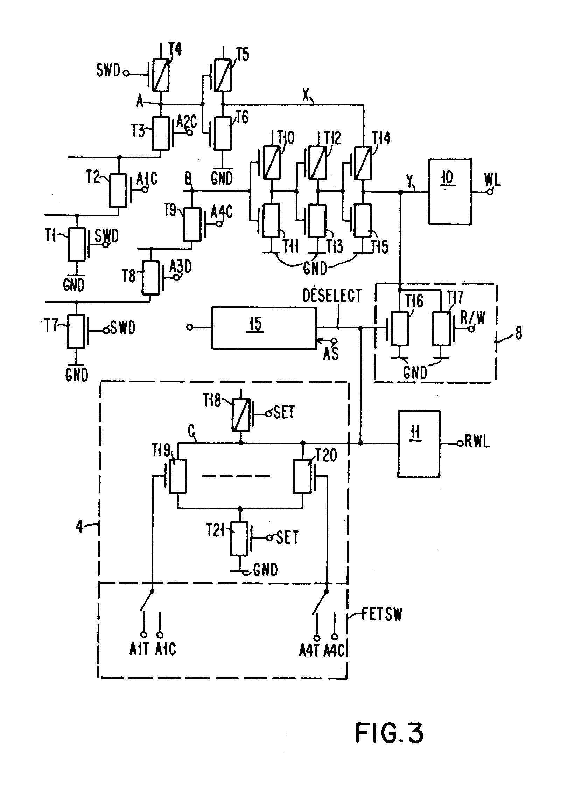

Im nachfolgenden wird nun die Detailschaltung nach Fig. 3 näher beschrieben. Die Wortleitungsdekodierung erfolgt hier über eine X-Y-Matrix. Der Einfachheit halber ist hier die Version für insgesamt vier Adressen gezeigt.

Hierbei sind nur die Transistoren T1, T2, T3 und T7, T8, T9 für die Adresskombination gezeigt; alle Komplementadress-Signale A1C bis A4C sind dabei auf "1". Die Selektion der Wortleitung WL tritt dann auf, wenn die Signale A1C bis A4C auf "1" sind und das Startsignal SWD, das den Wortdekoder setzt, aus der Zeitsignalkette des Speichers vorliegt.

Daraufhin wird der Knoten A entladen, und das Signal X auf dem gemeinsamen Ausgang vom Transistor T5 und vom Transistor T6 geht hoch. Gleichzeitig wird auch der Knoten B entladen, der sich am Ausgang des Transistors T9 befindet, wodurch das Signal Y, gesteuert über die zusätzlichen Inverter-Transistoren T12 und T13, auf Masse GND heruntergeht. Die Transistoren T14 und T15 bewirken nun die 1-aus-2-Dekodierung für die entsprechende Wortleitung WL.

Der redundante Pfad wird in dieser Schaltung durch die Transistoren T18 bis T21 dargestellt, die im wesentlichen dem Vergleicher 4 in Fig. 1 entsprechen. Die wahren bzw. die komplementären Signale für die Adressen werden über die "Fuses"-programmierten Feldeffekttransitor-Schalter FET SW geführt, wodurch sich eine extrem kleine Verzögerung ergibt und dann einer schnellen NOR-Stufe aus den Transistoren T18 bis T21 zugeführt wird. Diese NOR-Stufe wird mit einem Signal SET beaufschlagt, das ebenfalls aus der Zeitimpulskette des Speichers entnommen wird und zur gleichen Zeit oder früher kommt wie das Steuersignal SWD. Durch diese Tatsache ist die Selektion einer Wortleitung WL nur möglich, wenn der Clamp-Schaltkreis 8, aus den Transistoren T16 und T17 bestehend, freigegeben worden ist. Wenn der Vergleichsschaltkreis 4 kein "Match"-Signal hat, wird immer der Knoten C entladen, wodurch der gezeigte Transistor T16 des Clamp-Schaltkreises die Wortleitung WL über den Treiber 10 freigibt. In dem Fall, in dem ein "Match"-Signal vorhanden ist, werden die Transistoren T19 und T20 abgeschaltet, und der Knoten C entlädt sich nicht. Damit ist die entsprechende Wortleitung WL auf ihrem Potential festgehalten, und die entsprechende redundante Wortleitung RWL kann über den Treiber 11 aktiviert werden. Mit dem Transistor T17 läßt sich die Wortleitung WL ebenfalls abschalten, so daß bei Steuerung mit dem Lese-/Schreibsignal R/W eine Leistungsreduzierung erzielt werden kann. Mit dem Signal DESELECT am Knoten C läßt sich dann ebenfalls noch das Signal SWD wieder abschalten, wodurch der Dekoder einer Restoreoperation, gesteuert durch den Generator 15 zum Setzen des Wortdekoders (1 und 2), unterzogen wird. Durch die gesteuerte Wortleitungsabschaltung mit der Verknüpfung der Signale R/W, AS und SET SA wird die Verlustleistung bei dieser Schaltung drastisch gesenkt. Das Signal für die Speicherarray-Selektion AS triggert die entsprechende Wortleitung WL, worauf sich die Bitleitung zu entladen beginnt. Sobald nun ein V von ca. 0,5 Volt erreicht ist, wird ein zugehöriger nicht dargestellter Leseverstärker gesetzt. Der Leseverstärker muß gleichzeitig die Bitleitungen vom Datenpfad isolieren. Handelt es sich um einen Lesevorgang, so kann zu diesem Zeitpunkt die Wortleitung WL abschalten. Dies bedeutet gleichzeitig, daß das Potential der Bitleitung nicht mehr über die Speicherzelle weiter entladen wird. Es ist also nur um 0,5 Volt abgesunken und muß demzufolge auch bei der Restoreoperation nur um 0,5 Volt hochgezogen werden, wodurch sich eine sehr hohe Leistungsersparnis ergibt.

**Patentansprüche**

1. Verfahren zur Dekodierung von Wort- oder Bitleitungen in einem CMOS-Halbleiterspeicher mit redundanten Wort- oder Bitleitungen und Verbindungen (Fuses) zur Darstellung der Adressen der redundanten Wort- oder Bitleitungen, die über einen Vergleicher mit von außen an den Speicher zur gewünschten Selektion angelegten Adressen verglichen werden, indem die von außen angelegten Adressen gleichzeitig auf die Dekoder (1 und 2) des Speichers und auf einen Vergleicher (4) gegeben werden, an dem auch die Adressen (FA) für die Fuses anliegen, indem im Falle eines Match-Signales, hervorgerufen durch den Vergleich der von außen angelegten Adressen mit der Adresse, die durch die Fuses eingestellt ist, sofort die redundante Wortleitung (RWL) oder Bitleitung aktiviert wird und gleichzeitig alle Wort- (WL) oder Bitleitungen im unselektierten Zustand gehalten werden, dadurch gekennzeichnet,

   daß die Wort- oder Bitleitungen durch ein Clamp-Signal (DESELECT) gesteuert im unselektierten Zustand bleiben, daß dieses Clamp-Signal die Adressdekoder deaktiviert und eine Restoreoperation einleitet, und daß im Falle einer Leseoperation das Absinken des Potentials auf den Wort- oder Bitleitungen bis auf Masse (GND) durch ein frühes Abschalten der selektierten Wortleitung (WL) bzw. Bitleitung verhindert wird, und daß gleichzeitig mit dem Abschalten der Wortleitung (WL) bzw. Bitleitung beim Lesen der entsprechende Leseverstärker gesetzt wird, und

daß im Falle eine normalen Selektion einer Wortleitung (WL) bzw. Bitleitung am Ausgang (5) eines mit dem fuse-kontrollierten Schaltern (FET SW) verbundenen Vergleicher (4) kein Matchsignal erzeugt wird, wodurch ein Signal (DESELECT) am Ausgang (6) eines ODER-Schaltkreises (7) auf 0 Volt gebracht wird, daß dadurch der mit dem Ausgang des ODER-Schaltkreises (7) verbundene Clamp-Schaltkreis (8) abgeschaltet wird und damit eine dekodierte Adresse vom Ausgang (9) des Dekoders (1,2) auf eine nachgeschaltete Treiberschaltung (10) gelangt, die das Potential der damit verbundenen Wortleitung (WL) bzw. Bitleitung hochzieht.

2.  Schaltungsanordnung zur Durchführung des Verfahrens nach Anspruch 1, dadurch gekennzeichnet,
    daß der Dekoder für die Wortleitungen (WL) aus zwei Stufen (1 und 2) besteht, daß der Dekoder für die redundanten Wortleitungen (RWL) aus dem Vergleicher (4) und fuse-kontrollierten Schaltern (FET SW) besteht, daß die Eingangsadressen (A) für den Speicher über eine Leitung sowohl an den zweistufigen Adressendekoder (1 und 2) als auch an den Vergleicher (4) über Leitungen (3) parallel gelangen, daß der Ausgang des Vergleichers (4) über eine Leitung (5) direkt mit dem Treiber (11) für die redundante Wortleitung (RWL) verbunden ist und außerdem mit dem ODER-Schaltkreis (7), der seinerseits über eine Leitung (13) von der Lese-/Schreib-Steuerschaltung (12) gesteuert wird und über eine Leitung (6) sowohl mit den beiden Stufen (1 und 2) des Dekoders als auch mit dem Clamp-Schaltkreis (8) verbunden ist, der seinerseits ausgangsseitig direkt mit dem Eingang der Treiberschaltung (10) für die Wortleitung (WL) verbunden ist.

3.  Schaltungsanordnung nach Anspruch 2, dadurch gekennzeichnet,
    daß die gleichzeitige Adressierung der redundanten Wort- oder Bitleitung und der im Speicher vorhandenen Wortleitungen bzw. Bitleitungen über die Adressdekoder (1 und 2; 4) durch eine direkte Adressverbindung über fuse-kontrollierte Schalter (FET SW) erfolgt, und daß direkt am Ausgang (9) des Adressdekoders (1 und 2) für die Wort- oder Bitleitungen (WL) ein das Potential für die Wortleitungen (WL) bzw. Bitleitungen steuernder Clamp-Schaltkreis (8) unmittelbar vor den Treiberstufen (10) für die Wortleitungen (WL) bzw. Bitleitungen angeordnet ist.

4.  Schaltungsanordnung nach Anspruch 3, dadurch gekennzeichnet, daß beim Auftreten eines Matchsignals am Ausgang (5) des Vergleichers (4) die entsprechende redundante Wortleitung (RWL) bzw. Bitleitung über die mit ihr direkt verbundene Treiberschaltung (11) aktiviert wird, daß durch das Erhaltenbleiben des Signals (DESELECT) eine dekodierte Wortadresse durch den gesteuerten Clamp-Schaltkreis (8) nicht die dekodierte Wortleitung (WL) bzw. Bitleitung, sondern eine redundante Wortleitung (RWL) bzw. Bitleitung adressiert.

5.  Schaltungsanordnung nach einem der Ansprüche 2 bis 4, dadurch gekennzeichnet,
    daß die Lese-/Schreib-Steuerschaltung (12) Eingänge für die Lese- bzw. Schreibsteuersignale (R/W) aufweist, und außerdem einen Eingang für das Setzsignal (SET SA) des Leseverstärkers, und daß diese beiden Signale über einen Generator (15) mit einem Selektionssignal (AS) für ein Speicherarray logisch zum Setzen des Wortdekoders (1 und 2) und zum Einleiten einer Restoreoperation verknüpft sind.

**Claims**

1.  Method of decoding word or bit lines in a CMOS semiconductor memory with redundant word or bit lines and fuses for displaying the addresses of the redundant word or bit lines which, via a comparator, are compared with addresses externally applied to the memory for the desired selection, wherein the externally applied addresses are simultaneously fed to the decoders (1 and 2) of the memory and to a comparator (4) which also receives the addresses (FA) for the fuses, wherein, in the event of a match signal prompted by the comparison of the externally applied addresses with the address set by the fuses, the redundant word line (RWL) or bit line is immediately activated and all word (WL) or bit lines are simultaneously kept in the unselected state, characterized in that the word or bit lines, controlled by a clamp signal (DESELECT), remain in the unselected state, that this clamp signal deactivates the address decoders and initiates a restore operation, and that in the case of a read operation, a drop of the potential on the word or bit lines down to ground (GND) is prevented by an early switch-off of the selected word (WL) or bit line, and that simultaneously with the switching-off of the word (WL) or bit line, the corresponding read amplifier is set during reading, and that when a word (WL) or bit line at the output (5) of a comparator circuit (4), connected to the fuse-controlled switches (FET SW), is normally selected, no match signal is generated so that a signal (DESELECT) at the output (6) of an OR circuit (7) is switched to 0 Volt, that in response, the clamp circuit (8) connected to the output of the OR circuit (7) is switched off causing a decoded address from the output (9) of the decoder (1, 2) to reach a connected driver circuit (10) which pulls up the potential of the connected word (WL) or bit line.

2. Circuit arrangement for implementing the method as claimed in claim 1, characterized in that the decoder for the word lines (WL) consists of two stages (1 and 2), that the decoder for the redundant word lines (RWL) consists of the comparator (4) and fuse-controlled switches (FET SW), that the input addresses (A) for the memory, via lines (3), reach the two-stage address decoder (1 and 2) and the comparator (4) in parallel, that the output of the comparator (4), via a line (5), is directly connected to the driver (11) for the redundant word line (RWL) and, additionally, to the OR circuit (7) which in turn, via a line (13), is controlled by the read/write control circuit (12) and connected via a line (6) to the two stages (1 and 2) of the decoder and the clamp circuit (8) which in turn has its output side directly connected to the input of the driver circuit (10) for the word line (WL).

3. Circuit arrangement as claimed in claim 2, characterized in that the simultaneous addressing of the redundant word or bit line and the word or bit lines in memory is effected via the address decoders (1 and 2; 4) by a direct address connection through fuse-controlled switches (FET SW), and that at the output (9) of the address decoder (1 and 2) for the word (WL) or bit lines a clamp circuit (8) controlling the potential of the word (WL) or bit lines is directly arranged in front of the drivers (10) for the word (WL) or bit lines.

4. Circuit arrangement as claimed in claim 3,

characterized in that in response to a match signal at the output (5) of the comparator (4), the corresponding redundant word line (RWL) or bit line is activated via the driver circuit (11) directly connected thereto, that as a result of the signal (DESELECT) being maintained, a decoded word address, through the controlled clamp circuit (8), does not address the decoded word (WL) or bit line but a redundant word line (RWL) or bit line.

5. Circuit arrangement as claimed in any one of the claims 2 to 4, characterized in that the read/write control circuit (12) comprises inputs for the read or write control signals (R/W) and, additionally, an input for the set signal (SET SA) of the read amplifier, and that, through a generator (15), these two signals are logically combined with a selection signal (AS) for a memory array for setting the word decoder (1 and 2) and for initiating a restore operation.

**Revendications**

1. Procédé pour le décodage de lignes de mot ou de bit dans une mémoire à semi-conducteurs CMOS comportant des lignes de mot ou de bit redondantes ainsi que des connexions (fusibles) pour les informations d'adresse des lignes de mot ou de bit lesquelles sont comparées dans un comparateur à des adresses appliquées à la mémoire à partir d'une source externe pour la sélection recherchée, du fait que les adresses qui sont appliquées à partir d'une source externe au décodeur (1 et 2) de la mémoire ainsi qu'à un comparateur (4), auquel sont également appliquées les adresses (FA) correspondant aux fusibles, du fait que le comparateur produit un signal de concordance en résultat de la comparaison des adresses appliquées à partir d'une source externe et des adresses qui sont établies par l'intermédiaire des fusibles, la ligne de mot ou de bit (RWL) redondante est instantanément activée et simultanément toutes les lignes de mot ou de bit (WL) sont maintenues en état de non-sélection, caractérisé en ce que :

les lignes de mot ou de bit demeurent à l'état nonsélectionné au moyen d'un signal de blocage (DESELECTION), en ce que ce signal de blocage désactive le décodeur d'adresse et lance une opération de remise à zéro et en ce que, dans le cas d'une opération de lecture, l'abaissement du potentiel des lignes de mot ou de bit à la masse (GND) est interdit par une désactivation précoce de la ligne de mot (WL) ou de la ligne de bit sélectionnée et en ce que, simuitanément à la désactivation de la ligne de mot (WL) ou de la ligne de bit, l'amplificateur de lecture correspondant est activé au moment de la lecture, et en ce que,

dans le cas d'une sélection normale de ligne de mot (WL) ou de ligne de bit à la sortie (5) d'un comparateur qui est relié à un commutateur commandé par fusible (FET SW) aucun signal de concordance n'est produit, d'où il résulte qu'un signal (DESELECTION) délivré en sortie (6) d'un circuit OU (7) d'une tension de 0 volt est utilisé, en ce qu'ainsi le circuit de blocage (8) relié à la sortie du circuit OU (7) est désactivé, et, ainsi une adresse décodée délivrée en sortie (9) du décodeur (1 et 2) est appliquée à un circuit d'attaque (10) qui en est commuté, ce qui a pour effet d'élever le potentiel de la ligne de mot (WL) ou de la ligne de bit qui lui est reliée.

2. Circuit pour la mise en oeuvre de procédé selon la revendication 1, caractérisé en ce que le décodeur pour la ligne de mot (WL) est constitué de deux étages (1 et 2), en ce que le décodeur pour la ligne de mot redondante (RWL) est constitué d'un comparateur (4) et d'un commutateur commanda par fusible (FET SW), en ce que les adresses d'entrée (A) délivrées à la mémoire sont appliquées en parallèle par l'intermédiaire de la ligne (3) au décodeur à deux étages (1 et 2) et au comparateur (4), en ce que la sortie du comparateur (4) est reliée directement par une ligne (5) au circuit d'attaque (11) destiné à la ligne de mot redondante (RWL) et est également reliée au circuit OU (7), lequel, pour sa part, est activé par une ligne (13) du circuit de lecture/écriture (12) et dont une sortie (6) est reliée aussi bien aux deux étages (1 et 2) du décodeur qu'au circuit de blocage (8), celui-ci, pour sa part, étant relié directement en sortie à l'entrée du circuit d'attaque (10) destiné à la ligne de mot (WL).

3. Circuit selon la revendication 2, caractérisé en ce que
l'adressage instantané de la ligne de mot ou de la linge de bit redondante et de la ligne de mot c'est-à-dire de la ligne de bit présente dans la mémoire sur le décodeur d'adresse (1 et 2 ; 4) s'effectue à travers une liaison directe sur le commutateur commandé par fusible (FET SW) et en ce qu'un circuit de blocage (8) est disposé immédiatement en sortie (9) du décodeur d'adresse (1 et 2) pour la ligne de mot (WL) ou la ligne de bit directement avant les étages du circuit d'attaque (10)

4. Circuit selon la revendication 3, caractérisé en ce que la ligne de mot ou la ligne de bit correspondante est activée par l'application d'un signal de concordance à la sortie (5) du comparateur (4) sur le circuit d'attaque (11) qui lui est directement reliée, en ce que en désactivant le signal (DESELECTION) une adresse de mot décodée n'accède pas par l'activation du circuit de blocage (8) à la ligne de mot (WL) ou la ligne de bit décodée mais à une ligne de mot redondante (RWL).

5. Circuit selon l'une quelconque des revendications 2 à 4, caractérisé en ce que
le circuit de lecture/écriture comporte des entrées pour les signaux de commande respectivement de lecture et d'écriture (R/W) ainsi qu'une entrée pour le signal de validation (SET SA) délivré par l'amplificateur de lecture, et en ce que ces deux signaux sont associés dans un générateur (15) à un signal de sélection (AS) pour la validation par une logique de commande de mémoire du décodeur de mot (1 et 2) et pour lancer une opération de remise à l'état initial.

FIG.1

FIG.2

FIG.3